**Europäisches Patentamt**

**European Patent Office**

**Office européen des brevets**

(11) Veröffentlichungsnummer : **0 219 763 B1**

(12) **EUROPÄISCHE PATENTSCHRIFT**

(45) Veröffentlichungstag der Patentschrift :
**05.06.91 Patentblatt 91/23**

(51) Int. Cl.$^5$ : **H01L 31/06, H01L 31/02**

(21) Anmeldenummer : **86113926.9**

(22) Anmeldetag : **08.10.86**

(54) **Solarzelle.**

(30) Priorität : **11.10.85 DE 3536299**

(43) Veröffentlichungstag der Anmeldung :
**29.04.87 Patentblatt 87/18**

(45) Bekanntmachung des Hinweises auf die
Patenterteilung :
**05.06.91 Patentblatt 91/23**

(84) Benannte Vertragsstaaten :
**AT BE CH DE ES FR GB GR IT LI LU NL SE**

(56) Entgegenhaltungen :
**EP-A- 0 118 797
DE-A- 1 614 832
DE-A- 2 846 097
FR-A- 2 303 384
GB-A- 2 034 973**

(56) Entgegenhaltungen :
**APPLIED PHYSICS LETTERS, Band 39, Nr. 1, 1.
July 1981, Seiten 83-85, American Institute of
Physics, New York, US; N.G. TARR et al.:
"Induced back-surface field solar cells on
p-type silicon substrates"
PATENTS ABSTRACTS OF JAPAN, Band 9, Nr.
140 (E-321)[1863], 14. Juni 1985; & JP-A-60 22
380**

(73) Patentinhaber : **NUKEM GmbH
Industriestrasse 13
W-8755 Alzenau (DE)**

(72) Erfinder : **Hezel, Rudolf, Dr. Dipl.-Phys.
Ringstrasse 23
W-8521 Spardorf (DE)**
Erfinder : **Hackstein,Karl
Gerhard,Dr.Dipl.-Chem.
Röntgen-Strasse 20
W-6450 Hanau(Main) (DE)**

(74) Vertreter : **Stoffregen, Hans-Herbert, Dr.
Dipl.-Phys.
Patentanwalt, Salzstrasse 11 a, Postfach 21 44
W-6450 Hanau (Main) 1 (DE)**

## Beschreibung

Die Erfindung bezieht sich auf eine Solarzelle aus einem Halbleitermaterial wie Silizium, in deren Halbleitersubstrat durch Strahlungsenergie Majoritäts- und Minoritäts-Ladungsträger erzeugt werden, die durch ein auf einer Seite des Halbleitersubstrats erzeugtes elektrisches Feld trennbar und sodann ableitbar sind, mit auf einer Seite des Halbleitersubstrats angeordneten ersten zueinander beabstandeten und untereinander verbundenen und unmittelbar auf dem Halbleitersubstrat angeordneten Ohm'schen Kontaktbereichen und mit zumindest einem auf der anderen Seite des Halbleitersubstrats angeordneten Metallkontakt, wobei die Ohm'schen Kontaktbereiche und das zwischen diesen verlaufende Halbleitersubstrat von einer Passivierungsschicht abgedeckt sind.

Der Preis eines Solarzellenmoduls setzt sich zu unterschiedlichen Anteilen aus den Kosten für die Solarzelle selbst und denen der Verkapselung sowie Rahmung der Zellenanordnung zu Modulen zusammen. Bei der Herstellung der Solarzelle geht neben den eigentlichen Prozeßkosten als wesentlicher Faktor der Preis für das Halbleitermaterial ein. Deshalb werden weltweit große Anstrengungen unternommen, billiges Halbleitermaterial zu entwikkeln, wobei meist eine Verschlechterung der elektrischen Eigenschaften und damit eine Reduzierung des Solarzellenwirkungsgrades in Kauf genommen werden muß.

Eine weitere Möglichkeit der Senkung der Solarzellenkosten insbesondere bei Verwendung von ein- und polykristallinem Silizium besteht darin, die Dicke des Halbleitersubstrats und damit den Materialaufwand drastisch zu reduzieren. Neben dieser Reduzierung des Halbleitermaterials, das sehr stark in den Gesamtpreis der Zelle eingeht, ergeben sich für dünne Solarzellen weitere Vorteile :

    – Erhöhung der Flexibilität der Solarzellen, die dadurch auch gekrümmten Oberflächen angepaßt werden können ;

    – Erhöhung des Verhältnisses von Leistung/Gewicht, ein Vorteil der insbesondere für die Verwendung im Weltraum, aber auch für terrestrische Zellen spricht ;

    – erhöhte Toleranz gegenüber hochenergetischer Strahlung im Weltraum.

    – Es können z.B. dünne Siliziumbänder verwendet werden, die umso wirtschaftlicher hergestellt werden können, je dünner sie sind ;

    – geringere Aufheizung der Zelle und damit höhere Betriebsspannung, sofern die Infrarotstrahlung nicht in der Zelle absorbiert wird.

    – Möglichkeit, bei geeigneter Strukturierung die von der Rückseite der Solarzelle auftreffende Strahlung auszunützen, so daß eine erheblich höhere elektrische Leistung erzielt werden kann.

Die Reduzierung der Solarzellendicke bringt jedoch auch schwerwiegende grundsätzliche Probleme mit sich. Sinkt die Dicke des Halbleitersubstrats unter die jeweilige Diffusionslänge der Minoritätsladungsträger, so tritt infolge erhöhter Rekombination der Ladungsträger an der Solarzellenrückseite eine erhebliche Verschlechterung der elektrischen Eigenschaften (Leerlaufspannung, Kurzschlußstrom) und damit des Wirkungsgrades der Solarzelle auf.

Bisher wird dieses Problem insbesondere bei Weltraumzellen durch die Erzeugung eines elektrischen Feldes auf der Solarzellenrückseite gelöst ("Back surface field" = BSF). Es wird eine Potentialschwelle für Minoritätsladungsträger and der Rückseite eingebaut, so daß diese nicht bis zum Ohm'schen Rückseiten Kontakt gelangen und dort rekombinieren können ; denn ein Ohm'scher Kontakt zeichnet sich durch eine extrem hohe Rekombinationsgeschwindigkeit aus.

Das elektrische Feld auf der Rückseite (BSF) kann dadurch erzeugt werden, daß Fremdatome auf der Rückseite durch Diffusion aus der Gasphase, durch Ionenimplantation oder sehr häufig durch einen Legierungsprozeß eingebracht werden. Bei einer $n^+p$ Silizium-Solarzelle werden z.B. Bor oder Al in das p-dotierte Siliziumsubstrat zur Erzeugung eines $pp^+$ Überganges eingebracht.

Dabei handelt es sich stets um aufwendige Hochtemperaturprozesse, wodurch neben einer möglichen Verringerung der Trägerlebensdauer im Halbleitervolumen zahlreiche Defekte im Bereich der Rückseite erzeugt werden, die die Wirksamkeit des elektrischen Feldes stark reduzieren und zu einer erheblichen Streuung der Solarzellendaten bei Großserienfertigung führen. Ferner treten Defekte an den Kanten der Solarzelle auf, es erfolgt ein unvollkommenes Legieren sowie eine schlechte Diffusion durch "diffusion pipes". Ferner ist ungleichmäßiges Eindringen des Rückseitenmetalls und Ausscheidung von Verunreinigungen festzustellen.

Der FR-A-2 303 384 ist eine Solarzelle zu entnehmen, bei der eine Passivierung auf dem Halbleitersubstrat zwischen zueinander beabstandeten und untereinander verbundenen Ohm'schen Kontakten im Hochtemperaturprozeß durch thermische Oxidation erfolgt. Eine Strukturierung der Oxidschicht erfolgt durch aufwendige Techniken wie Photolithographie und Ätzen des Oxids.

Aus der GB-A-2 034 973 ist eine Solarzelle der eingangs beschriebenen Art bekannt, bei der die partiell aufgetragenen Ohm'schen Kontakte auf der dem die Ladungsträger trennenden elektrischen Feld benachbarten Seite des Halbleitersubstrats angeordnet sind. Von den Ohm'schen Kontakten werden die Minoritätsladungsträger gesammelt. Die Majoritätsladungsträger werden von den Ohm'schen Kontakten durch eine Potentialbarriere wie hochdotierte n-Schicht bei einer pn-Solarzelle oder eine einen MIS-Kontakt bei einer MIS-Solarzelle ferngehalten.

Ausgehend von dem Stand der Technik gemäß dem Oberbegriff des Anspruchs 1 liegt der Erfindung die Aufgabe zugrunde, daß ohne Vorhandensein einer Potentialbarriere eine Reduzierung der Rekombination von Majoritäts- und Minoritätsladungsträger in der Umgebung des Ohm'schen Kontaktes erfolgt und daß herstellungsbedingt die Möglichkeit geschaffen wird, großtechnisch großflächige Solarzellen produzieren zu können. Dabei soll gleichzeitig gewährleistet sein, daß ein Eindringen von Fremdstoffen in die Solarzelle ausgeschlossen ist.

Die Aufgabe wird erfindungsgemäß dadurch gelöst, daß die zueinander beabstandeten Ohm'schen Kontaktbereiche auf der dem elektrischen Feld gegenüberliegenden Seite des Halbleitersubstrats angeordnet sind und die Majoritätsladungsträger sammeln und daß die Passivierungsschicht eine die Rekombination der Majoritäts- und Minoritätsladungsträger reduzierende isolierende Schicht ist.

Nach der erfindungsgemäßen Lehre dienen die partiell aufgetragenen Ohm'schen Kontakte als Majoritätsladungsträgersammler. Die Ohm'schen Kontakte sind unmittelbar auf dem Halbleitersubstrat aufgebracht, ohne daß eine Potentialbarriere vorhanden ist, die einen Typ der Ladungsträger von den Ohm'schen Kontakten zurückhält. Folglich können sowohl Majoritäts- als auch Minoritätsladungsträger in den Bereich der Ohm'schen Kontakte gelangen. Durch die Passivierungsschicht, die unmittelbar auf den Ohm'schen Kontakten und auf den dazwischenliegenden Bereichen des Halbleitersubstrats aufgebracht ist, wird die Rekombination der Ladungsträger reduziert. Gleichzeitig wirkt die Passivierungsschicht als Antireflexionsschicht.

Durch die flächige Passivierung ist auch der Vorteil gegeben, daß Fremdstoffe in die Solarzelle nicht eindringen und die Ohm'schen Kontakte nicht korrodieren können.

Durch die Reduzierung der Fläche des Ohm'schen Kontaktes vorzugsweise um mehr als 90% der Halbleitersubstratfläche wird dessen Einfluß bezüglich der Rekombinationsgeschwindigkeit entsprechend vermindert. Hierbei ist erwähntermaßen insbesondere von Bedeutung, daß die Rekombination der Ladungsträger im Gebiet zwischen den Teilbereichen des Ohm'schen Kontaktes durch die auch als Isolatorschicht zu bezeichnende Passivierungsschicht stark reduziert wird. Dies wird durch eine hohe Qualität der Passivierungsschicht/Halbleitergrenzfläche gewährleistet.

In Ausgestaltung der Erfindung wird das elektrische Feld vorzugsweise durch einen pn-Übergang oder einen MIS-Kontakt erzeugt. Dabei ist der MIS-Kontakt vorzugsweise aufgebaut aus p-Silizium, der natürlichen Silizium-Oxid-Schicht und/oder einer bei Temperaturen unterhalb 800°C erzeugten Silizium-Oxid-Schicht und Aluminium oder Magnesium, wobei sich der MIS-Kontakt über die gesamte Rückseite der Solarzelle erstrecken kann.

Zwischen dem Halbleitersubstrat und der ersten Passivierungsschicht kann sich ferner eine zweite Passivierungsschicht befinden.

Ferner kann nach einer weiteren Ausgestaltung der erfindung zwischen dem Halbleitersubstrat und der ersten Passivierungsschicht eine wasserstoffhaltige amorphe Siliziumschicht angeordnet sein, wodurch sich der Wirkungsgrad der Solarzelle positiv verändert.

Nach weiteren Ausgestaltungen der Erfindung zeichnet sich die erste Passivierungsschicht dadurch aus, daß diese Wasserstoff enthält. So kann sie aus Siliziumnitrid oder Siliziumnitrid bestehen, welches vorzugsweise durch Abscheidung aus der Gasphase in einem Reaktionsofen in der Glimmentladung, durch Lichteinwirkung oder durch Kathodenzerstäubung erzeugbar ist und zusätzlich Fremdionen wie Alkali-Ionen enthalten kann oder aus Aluminiumoxid oder Aluminiumoxinitrid besteht. Als optimale Dicken der ersten Passivierungsschicht ist der Bereich zwischen 2 bis 300 nm anzugeben.

Durch die nach der erfindungsgemäßen Lehre hergestellten Solarzellen, insbesondere bei auf der Rückseite vorhandenen Ohm'schen Kontaktbereichen, die sich nicht über die gesamte Halbleitersubstratrückenfläche erstrecken, ergeben sich folgende Vorteile:

1. Es ist ein geringer Prozeßaufwand erforderlich, um die Solarzellen herzustellen. Dabei erfolgt ein energiesparender und zuverlässiger Schichtabscheideprozeß bei niederen Temperaturen. Das Aufbringen der Passivierungsschichten kann in einem Zeitraum von 2 bis 10 Minuten bei Temperaturen von < als 600°C erfolgen.

2. Eine leichte Handhabung ist möglich, die bei extrem dünnen Zellen zur Erhöhung der Prozeßausbeute führt, da nur geringer Bruch anfällt.

3. Die Langzeitstabilität der Solarzellen wird durch gute Passivierung der Rückseite und des Randes erhöht, da die Passivierungsschicht ein Eindringen von Fremdatomen von außen verhindert und somit sowohl das Metall wie auch den Halbleiter vor Schädigung schützt.

4. Am Rand der Solarzelle wird eine Potentialbarriere aufgebaut, die ein direktes Abfließen von Minoritätsladungsträger von der Vorderseite zur Rückseite (Kurzschluß, Erniedrigung des Parallelwiderstandes) verhindert. Dies ist insbesondere bei den vorwiegend in Frage kommenden dünnen Solarzellen von Bedeutung. Es wird auch eine Kurzschlußmöglichkeit ausgeschlossen, falls die Vorderseitenmetallisierung irrtümlicherweise sich über den Rand erstrecken sollte.

5. Bei den Kanten der Solarzelle bedeckenden Passivierungsschichten kann der Vorderseitenkontakt zur Rückseite geführt und dort kontaktiert

werden. Beide Anschlüsse auf der Solarzellenrückseite bewirken den Vorteil, daß neben den Gewinnen aktiver Fläche auf der Vorderfläche durch das Wegfallen eines Kontaktierfeldes eine Vereinfachung und damit erhöhte Zuverlässigkeit des Kontaktiervorganges gegeben ist, ein Vorteil, der sich auch insbesondere bei automatisch ablaufenden Produktionsvorgängen bemerkbar macht.

6. Die als Isolator zu bezeichnende Passivierungsschicht auf der Rückseite erlaubt den Austritt von Wärmestrahlung. Hierdurch wird eine Aufheizung der Zelle vermindert, wodurch eine höhere Betriebsspannung erreicht wird.

7. Es erfolgt eine sehr gute Ausnutzung der von der Rückseite der Solarzelle auftreffenden Strahlung, wodurch eine sehr effektive und kostengünstige doppelseitig benutzbare Solarzelle zur Verfügung steht. Während bei der $p^+$ Diffusion eine relativ dicke tote Schicht zusammen mit einer hohen Oberflächenrekombinationsgeschwindig-keit $S_0$ entsteht und damit kurze Lichtwellenlängen sehr schlecht ausgenutzt werden, werden bei der erfindungsgemäßen Anordnung wegen des niederen Wertes von $S_0$ alle Wellenlängen gut erfaßt.

8. Die Passivierungsschicht wirkt gleichzeitig als Antireflexionsschicht.

9. Es ist problemlos ein Rückseitenreflektor auszubilden, in dem auf die Passivierungsschicht ganzflächig eine Metallschicht aufgebracht wird. An dieser wird zum einen die Wärmestrahlung reflektiert und zum Austreten aus der Solarzellenvorderseite gebracht, zum anderen wird auch der Weg der längerwelligen, aber noch zur Erzeugung von Elektronen-Lochpaaren nutzbaren Strahlung verlängert und damit der Kurzschlußstrom erhöht.

10. Es bestehen keine besonderen Anforderungen an das Vorhandensein bestimmter Ladungen in der Passivierungsschicht, wodurch der Prozeß wesentlich zurverlässiger gemacht wird. Im Gegensatz zur Vorderseite bei Inversionsschicht-Solarzellen, in denen notwendigerweise eine starke Inversion im Halbleiter durch entsprechende Isolatorladungen vorliegen muß, ist es nach dem erfindungsgemäßen Vorschlag unwesentlich, ob eine Anreicherung, Verarmung oder Inversion vorherrscht. Wesentlicher Vorteil der erfindungsgemäßen Lehre ist nämlich darin zu sehen, daß auch bei Vorliegen von Inversion (im Falle von Siliziumnitrid auf p-Silizium) die Anordnung optimal funktioniert und die Minoritätsladungsträger nicht vorwiegend entlang der leitfähigen Inversionsschicht zu den Ohm'schen Kontaktbereichen fließen und dort rekombinieren. Es soll jedoch angemerkt werden, daß sowohl bei Akkumulation wie auch bei Inversion die Oberflächenrekombinationsgeschwindigkeit etwas niedriger leigt als bei Verarmung, da in den ersten beiden Fällen Oberflächenzustände mit Ladungsträgern besetzt werden. Somit ist das Vorhandensein von Isolatorladungen vorteilhaft, neben der Hauptbedingung, daß niedrige Werte von Oberflächenzustandsdichten an der Isolator/Halbleitergrenzfläche vorliegen müssen.

In diesem Zusammenhang soll nicht versäumt werden zu erwähnen, daß es nach dem Stand der Technik zwar bereits Ohm'sche Rückseitenkontakte in Gitterstrucktur bekannt sind, die jedoch nur in Verbindung mit einer darunterliegenden ganzflächigen hochdotierten Zone vorliegen, z.B. einer $p^+$ Zone bei p-dotiertem Solarzellensubstrat. Dabei darf die $p^+$ Zone nicht zu dünn sein, da sich andernfalls der Dunkelstromanteil aus dieser Zone infolge erhöhter Rekombination erhöht. Eine Reduzierung der Spannung ist die Folge. Häufig werden auf die bekannte $p^+$ Zone noch eine Metall- oder Oxidschicht abgeschieden, die teils dazu dienen, die Oberflächenrekombinationsgeschwindigkeit zu reduzieren, teils als Rückseitenreflektor oder als Antireflexionsschicht wirken.

Weitere Einzelheiten, Vorteile und Merkmale der Erfindung ergeben sich nicht nur aus den Ansprüchen, den diesen zu entnehmendenMerkmalen – für sich und/oder in Kombination – sondern auch aus der nachfolgenden Beschreibung der Zeichnungen, der bevorzugte Ausfürungsformen zu entnehmen sind.

Es zeigen :

Fig. 1 Kapazität-Spannungskurven von bevorzugten Passivierungsschichten,

Fig. 2 eine erste Ausführungsform einer erfin-dungsgemäßen Siliziumsolarzelle mit frontseiti-gem Ohm'schen Kontakt,

Fig. 3 eine Siliziumsolarzelle mit rückseitigem Ohm'schen Kontakt und

Fig. 4 eine weitere Ausführungsform einer Siliziumsolarzelle mit rückseitigem Ohm'schen Kontakt.

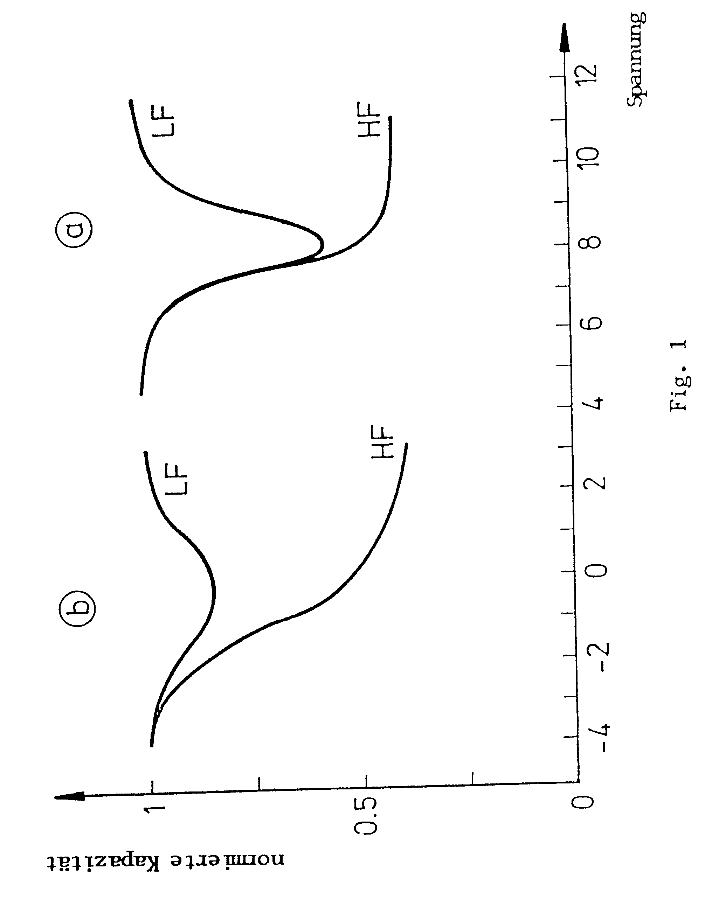

In Fig. 1 sind die Hoch- und Niederfrequenz-Kapazitäts-Spannungskurven der Kapazitätsstruktur von zur Oberflächenpassivierung besonders geeigneten ersten und zweiten Passivierungsschichten dargestellt. Dabei handelt es sich um einen Schichtaufbau von p (100) Silizium-Siliziumoxid-$Al_2O_3$-Alu-minum, wobei die Dicke der Siliziumoxidschicht 1,5 nm und die der $Al_2O_3$-Schicht 960 nm beträgt. Das Siliziumsubstrat mit (100) Orientierung ist p-dotiert. In der Kurve a ist die Hoch- und Niederfrequenz-Kapa-zitäts-Spannungskurve bei einer Abscheidetempera-ture des $Al_2O_3$ um 500°C, in der Kurve b bei 290°C dargestellt. Die $Al_2O_3$-Schicht wird dabei durch Pyrolyse der metallorganischen Verbindung Al-triisopropylat hergestellt. Das dünne Siliziumoxid enstand durch thermische Oxidation in $N_2/O_2$ Gas bei 510°C. Wie aus Fig. 1 ersichtlich ist, ergaben sich bei 290°C

$Al_2O_3$-Abscheidetemperatur negative Flachband-spannungen (d.h. positive Isolatorladungen) und hohe Oberflächenzustandsdichten ($D_{it} \sim 10^{12} cm^{-2} eV^{-1}$). Wesentlich günstiger wird es, wenn man $Al_2O_3$ bei 500°C abscheidet. Neben den nun negativen Isolatorladungen liegt vor allem eine erheblich niedrigere Oberflächenzustandsdichte $D_{it} = 8 \times 10^{10} cm^{-2} eV^{-1}$ vor, wodurch diese so präparierte Schichtstruktur gut brauchbar wird für die erfindungsgemäße Niedertemperatur-Oberflächenpassivierung von Solarzellen.

Noch etwas günstiger hinsichtlich der Oberflä-chenzustandsdichte und damit der Oberflächenre-kombinationsgeschwindigkeit gestalten sich die Verhältnisse bei der Verwendung von Plasma- Sili-ziumntrid. Im Gegensatz zu $Al_2O_3$ liegen dort stets positive Isolatorladungen vor. An p (100) Silizium – 1,5 nm Si-Oxid – 100 nm Si-Nitrid – Al Struckturen wurden bei 200°C Abscheidetemperatur (aus $NH_3$ + $SiH_4$) relativ hohe Oberflächenzustandsdichten ($D_{it} > 10^{12} cm^{-2} eV^{-1}$) gemessen. Nach einer Temperung bei 450°C jedoch sank dieser Wert bis $D_{it} < 1 \times 10^{10} cm^{-2} eV^{-1}$ ab. Änlich niedrige $D_{it}$-Werte erhält man auch durch die Abscheidung der Plasma-Siliziumnitridschichten bei Temperaturen zwischen 400°C und 500°C. Die positive Isolatorladungsdichte nimmt ebenfalls ab von $Q_f/q = 6,5 \times 10^{12} cm^{-2}$ bei 200°C auf $Q_f/q = 1 \times 10^{12} cm^{-2}$ bei temperaturen ab 400°C.

Bei hohen Temperaturen > 500°C steigt die Zustandsdichte wieder an, während die Ladungen nahezu konstant bleiben. Somit sind die Plasma-Siliziumnitridstrukturen wegen ihrer extrem niedrigen Oberflächenzustandsdichten bei Abscheide- bzw. Tempertemperaturen zwischen 400°C und 500°C für die Oberflächenpassivierung (niedrige Oberflächenrekombinationsgeschwindigkeit) von Solarzellen besonders gut geeignet. Dieses günstige Verhalten ist auf den in den Isolatorschichten vorhandenen Wasserstoff zurückzuführen, der die freien Bindungen des Siliziums absättigt.

Diese vorteilhafte Niedertemperaturpassivierung von Halbleiteroberflächen erlaubt es nun nach dem Erfindungsgedanken, wirkungsvolle Passivierung von Solarzellenoberflächen in Verbindung mit Ohm'schen Kontakten zu erreichen, d.h. die Isolatorschicht kann z.B. nach der Herstellung der Ohm'schen Al-Kontakte auf die Siliziumoberfläche und über diese Kontakte (was diese gleichzeitig vor Korrosion und Zerstörung schützt abgeschieden werden.

Eine Passivierung mit thermischen $SiO_2$ Schich-ten auf Silizium, die bei Temperaturen > 850°C hergestellt werden, würden neben der Hochtemperaturschädigung des Halbeleiters einen aufwendigen Photolithographieschritt mit Ätzen des $SiO_2$ erfordern, um nachträglich die Ohm'schen Kontakte aufbringen zu können. Diese wären dann auch nicht nach außen geschützt.

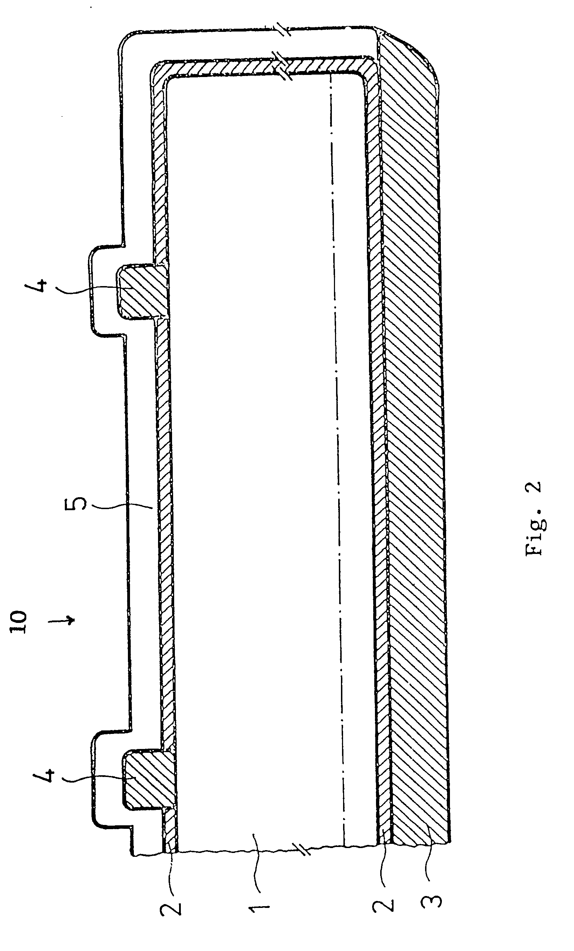

Die zuvor beschriebene Passivierungsmethode in der Umgebung von unmittelbar auf dem halbleitersubstrat vorhandenen Ohm'schen Kontaktbereichen gestattet es nun, insbesondere dünne Solarzellen-strukturen herzustellen, die sich durch Einfachheit kostengünstige Herstellung und Effektivität auszeichnen. In allen Fällen ist aber wichtig, die Fläche der Ohm'schen Kontakte (sehr hohe Rekombinationsrate) möglichst klein zu halten. An den Ausführungsbeispielen der Fig. 2 bis 4 sollen weitere Einzelheiten und Vorteile der Erfindung verdeutlicht werden.

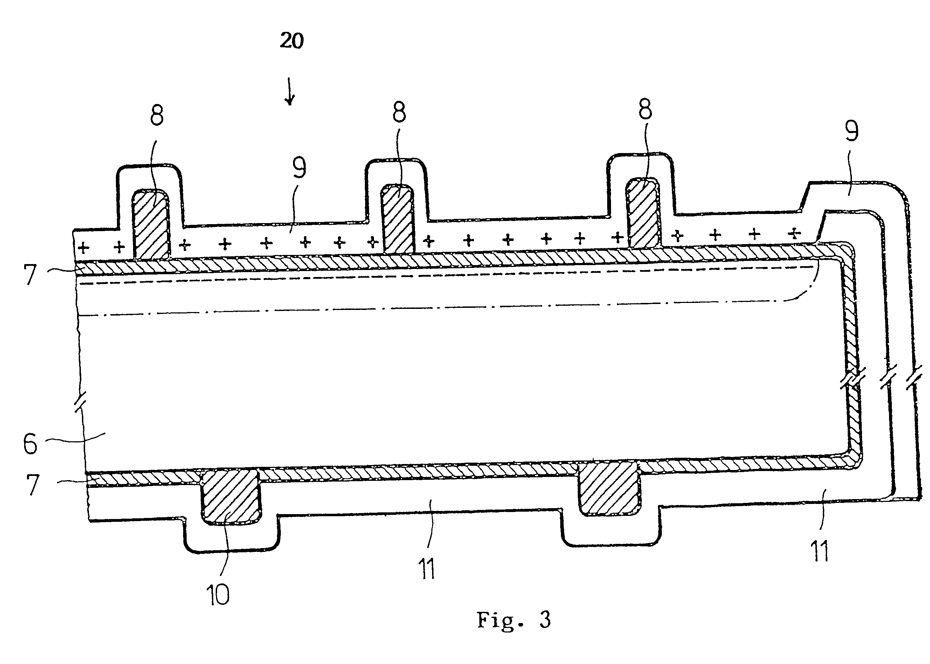

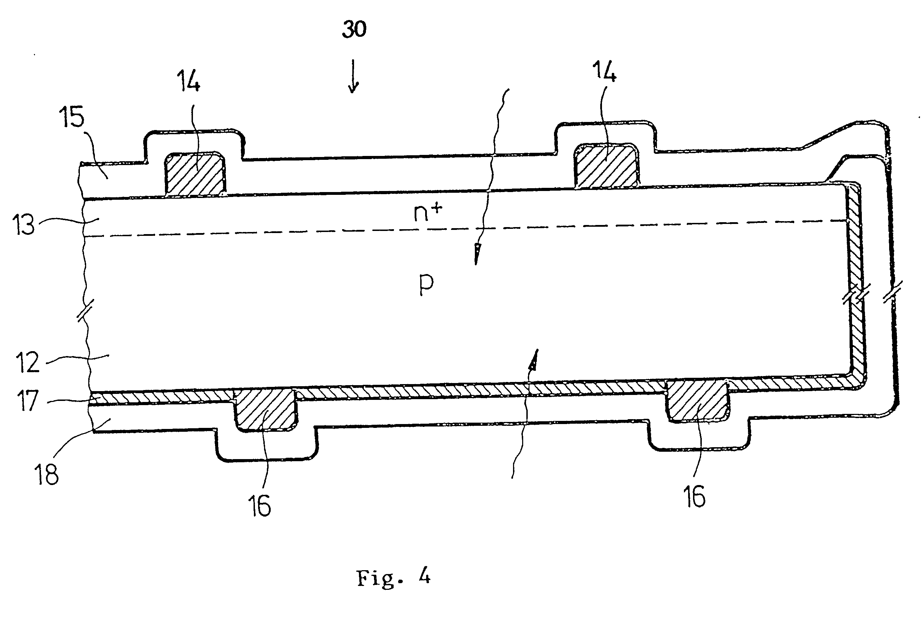

In Fig. 2 ist eine besonders hervorzuhebende erste Ausführungsform einer erfindungsgemäß aufgebauten Solarzelle 10 dargestellt, die aus einem p-dotierten Siliziumsubstrat als Körper 1, einer dünnen Siliziumoxidschicht 2, unmittelbar auf dem Siliziumkörper 1 angeordneten Ohm'schen Kontakten 4 sowie einem MIS-(Metal-Insulator-Semiconductor) Kontakt besteht, der sich seinerseits aus dem p-Silizium des Siliziumskörpers 1, der Siliziumoxidschicht 2 und einer Metallisierung 3 vorzugsweise aus Aluminium oder Magnesium zusammensetzt. Durch das einfallende Licht werden im Siliziumkörper 1 Elektronen und Löcher erzeugt. Die Elektronen (Minoritäts-ladungsträger) diffundieren zum rückseitigen MIS-Kontakt 1, 2, 3 und werden durch dessen elektrisches Feld nach Durchtunneln der Oxidschicht 2 ins Metall 3 abgesaugt. Die Löcher (Majoritätsladungsträger) diffundieren zur Vorderseite und verlassen das Silizium über die Ohm'schen Kontakte 4. In einem äußeren Kreis fließt daher ein elektrischer Strom (vorderseite + Pol, Rückseite – Pol der Solarzelle 10, (im Gegensatz zur Solarzelle 20 (Fig. 3) Solarzelle 30 (Fig. 4))). Da die Siliziumozidschicht 2 des MIS-Kontaktes als Tunnelisolator für die Minoritätsladungsträger wirkt, sollte eine Dicke von 3 nm nicht überschritten werden. Die Grenze der Raumladungszone des MIS-Kontaktes ist in der Zeichnung strichpunktartig angedeutet. Das dort herrschende elektrische Feld dient zur Sammlung der Minoritätsladungstäger. Die Ohm'schen Kontakte 4 sind erkennbar diskontinuierlich auf dem Halbleitersubstrat aufgebracht, also nicht flächenddeckend. Dabei können die Ohm'schen Kontakte 4 eine Geometrie bilden, die durch miteinander verbundene Streifen, Ringe oder Punkte gebildet werden. Zwischen den Ohm'schen Kontaktbereichen 4 erstrecken sich nun Passivierungsschichten, die zum einen aus der natürlichen oder auch unterhalb von 800°C erzeugten Siliziumoxidschicht 2 und einer weiteren Isolatorschicht zusammensetzt, die zum einen einer Passivierung und zum anderen als Antireflektionsschicht deinen kann. Die Dicke der oberen als erste bezeichnete Passivierungsschicht 5 kann dabei ungefähr 80 nm betragen und besteht vorzugsweise aus Aluminiumoxid oder Siliziumnitrid.

Die weitere Isolatorschicht, die als zweite Passivierungsschicht bezeichnet wird, in Form der Siliziumoxidschicht 2 kann auf der Vorder und Rückeite des

Siliziumsubstrats 1 unterschiedlich aufgebaut sein. So kann auf der Vorderseite die Dicke in weiten Grenzen variiert werden, da sie nicht als Tunnelisolator wirkt. Selbstverständlich kann die Schicht 2 auch vollständig entfallen, also auch im Bereich der ersten Passivierungsschicht 3 – wie im übrigen auch bei den Ausführungsbeispielen der Fig. 3 und 4 –.

Für den für die Erfindung wesentlichen Effekt der Grenzflächenpassivierung kann sowohl die natürliche Siliziumoxidschicht als auch eine beispielsweise durch thermische oder anders geartete Oxidation speziell präparierte Siliziumoxidschicht 2 verwendet werden. Unter natürlicher Siliziumoxidschicht versteht man diejenige, die stets auf dem Siliziumsubstrat 1 vorhanden ist und nur wenige Atomlagen dick ist.

Die Siliziumoxidschicht 2 selbst kann auf der Vorderseite durch die nachfolgende Abscheidung der ersten Passivierungsschiecht 5 – z.B. Siliziumnitrid – in ihrer Strukturzusammensetzung verändert werden. So kann z.B. eine Umwandlung von Siliziumoxid in Siliziumoxynitrid erfolgen.

Anders als bei konventionellen Solarzellen müssen die in der Hauptsache nahe der Frontseite durch das Licht erzeugten Ladungsträger erst durch das ganze Substrat 1 diffundieren, um vom rückseitigen MIS-Kontakt gesammelt zu werden. Dabei ist es wichtig, daß die Vorderseite eine niedrige Oberflächenrekombinationsgeschwindigkeit besitzt, da andernfalls ein großer Teil der Ladungsträger dort schon rekombinieren würde. Der Abstand der durch sehr hohe Rekombination gekennzeichneten Ohm'schen Kontaktbereiche 4, die auch als Kontaktfinger bezeichnet werden, soll wesentlich größer sein als die Substratdicke d bzw. die Diffusionslänge der Minoritätsladungsträger, so daß im Mittel der Weg zum sammelnden MIS-Kontakt geringer ist als zu dem Ohm'schen Kontaktbereich. Nach oben ist der Abstand der Ohm'schen Kontaktfinger 4 durch den Serienwiderstand begrenzt, der durch zu geringe Ohm'sche Kontaktflächen zum Siliziumkörper 1 erhöht wird. Der optimale Abstand liegt im Bereich von 1 bis 5 mm, die Fingerbreite im Bereich von 50-300 µm, wodurch sich ein Kontaktflächenanteil von weniger als 10% erreichen läßt. Die Zelle 10 hat, im Gegensatz zu den herkömmlichen Zellen, bei denen die sammelnden Kontakte sich auf der Vorderseite befinden, einen umso höheren Sammlungswirkungsgrad, je dünner das Halbleitersubstrat und je größer seine Diffusionslänge L ist (d ≤ L). Das Maximum des Wirkungsgrades ergibt sich bei einer Dicke d des Siliziumsubstrats 1 von etwa 50-80 µm. Deshalb kann teures Halbleitermaterial eingespart werden, was zu einer erheblichen Verbilligung der Solarzelle führt. Ein weiterer Vorteil dieser Zelle besteht darin, daß das rückseitige Metall 3 als Reflektor für die großen Lichtwellenlängen dient, was zu einer Erhöhung des Kurzschlußstromes und zu einer geringeren Aufheizung während des Betriebes der Zelle (höhere Leerlaufspannung) führt. Weiterhin wird für den Stromfluß der gesamte Zellenquerschnitt ausgenützt, die Minoritätsladungsträger müssen nicht in einem schmalen Gebiet hohen Schichtwiderstandes (z.B. $n^+$ Emittergebiet be $n^+p$ Solarzelle) entlang der Oberfläche zu den Kontakten fließen. Es ist somit auch ein hoher Füllfaktor vorprogrammiert. Die Solarzelle 10 ist deshalb auch besonders für konzentriertes Sonnenlicht geeignet.

Es besteht auch die Möglichkeit, den MIS-Rückseitenkontakt nicht flächig, sondern z.B. in Gitterform auszubilden, wobei der Zwischenraum zwischen den MIS-Kontakten mit einer Isolatorschicht (vorzugsweise Siliziumnitrid) ausgefüllt ist. Die Isolatorschicht muß z.B. bei p-Silizium positive Ladungen enthalten, um im Silizium eine Inversionsschicht zu influenzieren, entlang der die Minoritätsladungsträger (bei p-Si Elektronen) zu den MIS-Kontakten gelangen können. Dabei sind zwei Ausführungsformen möglich :

a) Die Isolatorschicht kann dabei – wie im Falle der Vorderseite der in Fig. 3 gezeigten MIS-Inversionsschicht Solarzelle 20 – sich über die MIS-Kontakte erstrecken, d.h. ihre Abscheide- bzw. Nachbehandlungstemperatur muß entsprechend niedrig sein (≤ 350°C bei Al/SiO$_x$/p-Si MIS-Kontakten), damit die MIS-Kontakte nicht zerstört werden. Das ist technologisch ein sehr einfacher Prozeß, wobei gleichzeitig erreicht wird, daß die Solarzelle auch von der Rückseite beleuchtet werden kann.

b) Es kann aber auch die Isolatorschicht auf der Rückseite durchbrochen sein, wobei auf dem dünnen Oxid (~ 1 nm-1,5 nm) in diesen bereichsweise sich erstreckenden wie fingerförmigen Öffnungen sich das Metall (MIS-Kontakt) befindet (doppelseitig beleuchtbare Solarzelle). Die Metallisierung kann sich aber auch über die gesamte Isolatorschicht (z.B. dünnes Siliziumoxid/Siliziumnitrid) erstrecken, wodurch ein idealer Rückseitenreflektor erreicht wird.

Die unter b) genannten Strukturen mit der durchbrochenen Isolatorschicht erlauben es, die Isolatorschicht bei höheren Temperaturen (≤ 600°C) vor der Metallisierung aufzubringen und damit bessere Grenzflächeneigenschaften (niedrigere Oberflächenzustandsdichte u.a.) zu erreichen. Der Herstellprozeß ist jedoch durch die Anwendung der Photolithographie und Justierung wesentlich aufwendiger.

In den Fig. 3 und 4 sind weitere Ausgestaltungen von Solarzellen 20 bzw. 30 dargestellt, die der erfindungsgemäßen Lehre gehorchen. Dabei ist der jeweilige Ohm'sche Kontakt auf der Rückseite der Solarzelle 20 bzw. 30 angeordnet, und zwar ebenfalls bereichsweise, wie im Zusammenhang mit der Fig. 2 bereits verdeutlicht. Die in Fig. 3 dargestellte Solarzelle 20 entspricht dem grundsätzlichen Aufbau nach der in der DE-PS 28 40 096 beschriebenen Siliziumnitrid-Inversionsschicht-Solarzelle mit MIS-Kontakt. So befindet sich auf einem Siliziumsubstrat bzw. -körper 6 eine dünne Siliziumoxidschicht 7, die insbesondere im Bereich der MIS-Kontakte der Oxidschicht 2 auf der Rückseite der in Fig. 2 gezeigten Solarzellenstruktur entspricht. Im Bereich zwischen den MIS-Kontakten kann die Oxidschicht 7 in ihrer Dicke in weiten Grenzen variiert werden ; es gilt dort das für die Oxidschicht 2 auf der Vorderseite der in der Fig. 2 dargestellten Solarzellenstruktur 10 Ausgesagte. Die Metalle 8 vorzugsweise in Form von Aluminium oder Magnesium der MIS-Kontakte sind auf der Vorderseite der Solarzelle 20 vorzugsweise in Streifenform angeordnet. Über die gesamte Oberfläche der Solarzelle erstreckt sich eine weitere Isolatorschicht 9, die vorzugsweise aus Siliziumnitrid besteht. In dieser Siliziumnitridschicht 9 muß sich eine hohe Dichte positiver Ladungen bestehend aus den natürlichen Ladungen und den durch Fremdionen eingebrachten befinden, die an der Oberfläche des p-dotierten Siliziumsubstrats 6 eine aus Elektronen bestehende Inversionsschicht induzieren. Die durch das Licht erzeugten Elektronen (Minoritätsladungsträger) diffundieren, im Gegensatz zu der Solarzelle 10 (Fig. 2), zur Vorderseite, werden in dem durch die positiven Isolatorladungen erzeugten elektrischen Feld beschleunigt und wandern entlang der gut leitenden Inversionsschicht zu den MIS-Kontakten 6, 7, 8, durch die sie den Siliziumkörper 6 verlassen und in einen äußeren Stromkreis gelangen. Die Löcher diffundieren zur Rückseite und verlassen den Siliziumkörper 6 über die Ohm'schen Kontakte 10 (Vorderseite – Pol, Rückseite + Pol der Solarzelle 20 (wie auch bei der Solarzelle 30 (Fig. 4))). Durch die Passivierung des Gebietes zwischen den Ohm'schen Kontakten 10 wird vermieden, daß dort, insbesondere auch beim Lichteinfall von der Rückseite, die Elektronen mit den Löchern rekombinieren und damit einer Nutzung verlorengehen. Die hohe Dichte positiver Ladung ist in der Schicht 9 durch Pluszeichen, die Inversionsschicht durch die gestrichelte Linie angedeutet. Ferner ist mit der strichpunktierten Linie die Breite der Raumladungszone angedeutet. Die Siliziumnitridschicht 9 kann – im Gegensatz zu der in den vorliegenden Erfindung angesprochenen Passivierungsschicht (Schicht 5 in Fig. 2, Schicht 11 in Fig. 3 und Schicht 18 in Fig. 4) – nur bei niedrigen Temperaturen (≤ 300°C) abgeschieden oder getempert werden, da andernfalls die MIS-Kontakte stark beeinträchtigt werden würden.

Deshalb kann auf der Vorderseite auch nicht auf einfache Weise der in der vorliegenden Erfindung beschriebene Effekt der Erniedrigung der Oberflächenrekombinationsgeschwindigkeit durch Aufbringen oder Tempern von Passivierungsschichten bei Temperaturen zwischen 300°C und 600°C ausgenützt werden. Dies kann z.B. nur durch einen aufwendigeren Prozeß erreicht werden, indem die Isolatorschicht 9 auf der Vorderseite durchbrochen wird und in diesen fingerförmigen Öffnungen durch Metallstreifen 8 der MIS-Kontakt erzeugt wird. Dadurch kann auch hier die Isolatorschicht bei höheren Temperaturen (≤ 600°C) aufgebracht oder getempert werden, gefolgt von der Metallabscheidung. Im Gegensatz zum obigen Fall sind aber aufwendige Strukturierungsschritte erforderlich. Die Rückseite der Solarzelle nach Fig. 3 besteht aus streifenförmigen Ohm'schen Kontakten 10 (vorzugsweise Al) und der zwischen diesen und im Randbereich liegenden Doppelisolatorschicht, die aus der dünnen Siliziumoxidschicht 7 und der Isolatorschicht 11, vorzugsweise aus Al-Oxid oder Si-Nitrid, gebildet wird.

Diese im Mittelpunkt der vorliegenden Ausführungsbeispiele stehende Rückseitenanordnung entspricht der Vorderseite der in Fig. 2 dargestellten Solarzelle 10, insbesondere ist auf die dort gemachten Anmerkungen bezüglich der Oxidschicht 2 (entspricht Schicht 7 in Fig. 3) hinzuweisen.

Die Rückseitenpassivierung in Kombination mit dem Ohm'schen Kontaktbereich 10 stellt einen zu diesem Niedertemperaturzelltyp (MIS-Inversionssicht-Solarzelle) voll kompatiblen Prozeß dar, da eine Temperaturbehandlung zwischen 400°C und 600°C, wie sie bei der Abscheidung oder Temperung der Rückseitenisolatorschicht 11 zur Anwendung kommt, ohnehin zur Erzeugung der Tunneloxidschicht 7 auf der Vorderseite und zur Formierung der Ohm'schen Kontakte 10 erforderlich ist. Diese Prozesse erfolgen natürlich vor der Bildung der MIS-Kontakte 8 und der Abscheidung der Antireflexionsschicht 9 auf der Vorderseite. Dieser Zelltyp ist besonders für dünne Substrate 6 geeignet, bei denen gewöhnlich die Randpassivierung zur Verhinderung eines Kurzschlusses zwischen Vorder- und Rückseite ein Problem darstellt. Dies wird hier automatisch gelöst durch das Aufbringen der Passivierungsschichten, also der Isolatorschichten. Wie aus Fig. 3 ersichtlich ist, bildet sich nämlich im Halbleiter an der Zellenoberseite im Randbereich durch Überlapping der beiden Isolatorschichten 9 und 11 eine Potentialbarriere aus, die ein Abfließen der Ladungsträger an der Halbleiteroberfläche im Randbereich zur Rückseite verhindert. Diese Potentialbarriere entsteht dadurch, daß sich im Vorderseitenisolator 9 eine hohe positive Ladungsdichte, im rück- und randseitigen Isolatorfilm 11 eine negative oder zumindest eine stark reduzierte positive Ladungsdichte befindet. Wie aus Fig. 3 ersichtlich, ist die gesamte Solarzelle 20 von den undurchlässigen Isolatorschichten 9 und 11 umhüllt, und damit vor äußeren Einflüssen geschützt. Durch die mit dieser Erfindung eingeführte Rückseitenpassivierung können nun alle Vorteile einer dünnen Solarzelle erreicht werden, einschließlich der reduzierten Aufheizung.

Als besonderer Vorteil zeigt sich daher, daß die Zelle 20 nun sehr effektiv die auf beide Oberflächen auftreffende Strahlung ausnutzt, also auch die hinten auftreffende, an weißen Flächen reflektierte oder gestreute Strahlung. Die Isolatorschicht 11 auf der Rückseite dient daher gleichzeitig als Antireflexionsschicht. Dadurch kann die von der Zelle 20 abgegebene Leistung erheblich gesteigert werden. Es wurde also bei vermindertem Aufwand an teurem Halbleitermaterial 6 fast ohne zusätzliche Kosten ein einfacher, bei niederen Temperaturen herzustellender Zellentyp geschaffen, mit dem das Sonnenlicht wesentlich mehr ausgenützt werden kann. Insbesondere auch das kurzwellige Licht wird wegen der höheren Güte der Rückseite gut verwertet. Bisherige Erfahrungen zeigen, daß das hinten auftreffende Licht mit einem nur um etwa 10% gegenüber der Vorderseitenbeleuchtung reduzierten Wirkungsgrad in Strom umgewandelt wird. Wenn die von hinten auftreffende Strahlung nicht genutzt werden soll, dann läßt sich einfach durch Aufbringen einer Metallschicht auf den Rückseitenisolator 11 ein Rückseitenreflektor erzeugen. Außerdem können Vorder- und Rückseite texturiert werden zur Erhöhung des Lichteinfalls.

Anhand der Fig. 4 soll eine der erfindungsgemäßen Lehre gehorchende Solarzelle 30 beschrieben werden, bei der es sich um eine konventionelle n⁺p oder p⁺n-Solarzelle handeln kann. Die im Ausführungsbeispiel dargestellte n⁺p-Solarzelle 30 umfaßt ein Halbleitersubstrat 12, eine hoch dotierte Oberflächenschicht 13 (hier n⁺), auf der Vorderseite einen nicht flächig angeordneten Ohm'schen Kontakt 14 in Form eines Gitters und eine vorderseitige Antireflektionsschicht 15. Auf der Rückseite befinden sich ebenfalls nicht flächig angeordnete, vorzugsweise gitterförmig ausgebildete Ohm'sche Kontakte 16 und die die vorliegende Erfindung kennzeichnenden Passivierungsschichten vorzugsweise in Form einer Siliziumoxidschicht 17 und einer auch als Antireflektionsschicht wirkenden Isolierschicht 18. Dabei wird die Isolierschicht 18 vorzugsweise aus Aluminiumoxid oder Siliziumnitrid gebildet. Durch die erfindungsgemäße rückwärtige Ausbildung der n⁺p-Solarzelle 30 wird auf einfache Weise eine beidseitig beleuchtbar Solarzelle mit dem zusätzlichen Vorteil zur Verfügung gestellt, daß jeweils die langwellige Wärmestrahlung aus der Zelle 30 austritt und damit die Betriebstemperatur (Erhöhung der Leerlaufspannung) sinkt. Ferner ist eine Texturierung insbesondere der Rückseite leicht möglich. Neben der Randpassivierung durch die Schichten 17 und 18 kann eine völlige Umhüllung der Zelle 30 mit undurchlässigen Isolatorschichten 18 bzw. 15 als Schutz erreicht werden. Ferner kann eine Metallschicht als Rückseitenreflektor auf die Isolatorschicht 18 aufgebracht werden.

Diese Solarzelle 30 (Fig. 4) unterscheidet sich von der MIS-Inversionsschicht Solarzelle 20 (Fig. 3) dadurch, daß durch einen Hochtemperaturprozeß in dem Siliziumkörper 12 eine hoch mit Fremdatomen (z.B. Phosphor) dotierte Oberflächenschicht eingebracht wird, wodurch zwischen den Schichten 12 und 13 ein n⁺p-Übergang und damit ein elektrisches Feld erzeugt wird. Die durch das Licht generierten Elektronen wandern in Folge des elektrischen Feldes zur Oberfläche, wo sie entlang der gut leitenden n⁺-Schicht 13 zu dem Ohm'schen Kontakten 14 in einen äußeren Stromkreis gelangen. Die Löcher wandern zur Rückseite und verlassen den Siliziumkörper 12 über die Ohm'schen Kontakte 16 (Vorderseite – Pol, Rückseite + Pol der Solarzelle 30).

Während also bei der Solarzelle 30 der Siliziumkörper praktisch aus zwei Teilen 12 und 13 besteht, handelt es sich bei den Solarzellen 10 (Fig. 2) bzw. 20 (Fig. 3) um homogene Siliziumkörper 1 bzw. 6, die durch den Herstellprozeß der Zelle nicht verändert werden.

## Ansprüche

1. Solarzelle (10, 20, 30) aus einem Halbleitermaterial wie Silizium, in deren Halbleitersubstrat (1, 6, 12, 13) durch Strahlungsenergie Majoritäts- und Minoritäts-Ladungsträger erzeugt werden, die durch ein auf einer Seite des Halbleitersubstrats erzeugtes elektrisches Feld trennbar und sodann ableitbar sind, mit auf einer Seite des Halbleitersubstrats angeordneten ersten zueinander beabstandeten und untereinander verbundenen und unmittelbar auf dem Halbleitersubstrat angeordneten Ohm'schen Kontaktbereichen (4, 10, 16) und mit zumindest einem auf der anderen Seite des Halbleitersubstrats angeordneten Metallkontakt (3, 8, 14), wobei die Ohm'schen Kontaktbereiche und das zwischen diesen verlaufende Halbleitersubstrat von einer Passivierungsschicht (5, 11, 18) abgedeckt sind, **dadurch gekennzeichnet**, daß die zueinander beabstandeten Ohm'schen Kontaktbereiche (4, 10, 16) auf der dem elektrischen Feld gegenüberliegenden Seite des Halbleitersubstrats (1, 6, 12, 13) angeordnet sind und die Majoritätsladungsträger sammeln und daß die Passivierungsschicht (5, 11, 18) eine die Rekombination der Majoritäts- und Minoritäts-Ladungsträger reduzierende isolierende Schicht ist.

2. Solarzelle nach Anspruch 1, **dadurch gekennzeichnet**, daß die Ohm'schen Kontaktbereiche (4) auf der Vorderseite der Solarzelle (10) angeordnet sind, daß das elektrische Feld auf der Rückseite der Solarzelle (10) erzeugbar ist und daß das Halbleitersubstrat (1) eine Dicke aufweist, die in etwa kleiner oder gleich der Diffusionslänge der Minoritätsladungsträger in dem Halbleitersubstrat ist.

3. Solarzelle nach Anspruch 1, **dadurch gekennzeichnet**, daß die Passivierungsschicht (5, 11, 18) aus einem anderen Material als das aus oder auf dem Halbleitersubstrat (1, 6, 12, 13) gebildete Oxid ist.

4. Solarzelle nach Anspruch 1, **dadurch gekenn-**

zeichnet, daß das Halbleitermaterial (6, 12, 13) eine Dicke aufweist, die in etwa kleiner oder gleich der Diffusionslänge der Minoritätsladungträger entspricht.

5. Solarzelle nach Anspruch 1, **dadurch gekennzeichnet**, daß die Fläche der Ohm'schen Kontaktbereiche (4, 10, 16) weniger als 20% der Halbleitersubstratfläche abdeckt.

6. Solarzelle nach Anspruch 1, **dadurch gekennzeichnet**, daß das elektrische Feld durch vorzugsweise einen pn-Übergang (12, 13) oder einen MIS-Kontakt (1, 2, 3) oder einen MIS-Kontakt (6, 7, 8) in Verbindung mit einer Ladungen enthaltenden Isolatorschicht (9) erzeugbar ist.

7. Solarzelle nach Anspruch 1, **dadurch gekennzeichnet**, daß die Passivierungsschicht eine erste Passivierungsschicht (5, 11, 18) ist und daß zwischen dem Halbleitersubstrat (1, 6, 12) und der ersten Passivierungsschicht (5, 11, 18) eine zweite Passivierungsschicht (2, 7, 17) angeordnet ist, die aus Siliziumoxid besteht, das ein natürliches Siliziumoxid oder durch eine thermische Oxidation erzeugtes Siliziumoxid ist, vorzugsweise kleiner oder gleich 5 nm Dicke beträgt.

8. Solarzelle nach Anspruch 1, **dadurch gekennzeichnet**, daß die Passivierungsschicht eine erste Passivierungsschicht (5, 11, 18) ist und daß zwischen dem Halbleitersubstrat (1, 6, 12) und der ersten Passivierungsschicht (5, 11, 18) eine wasserstoffhaltige amorphe Siliziumschicht angeordnet ist.

9. Solarzelle nach Anspruch 1, **dadurch gekennzeichnet**, daß die Passivierungsschicht (5, 11, 18) aus Siliziumnitrid oder Siliziumoxinitrid besteht, welches vorzugsweise durch Abscheidung aus der Gasphase in einem Reaktionsbehälter in einer Glimmentladung, durch Lichteinwirkung oder durch Kathodenzerstäubung erzeugbar ist und gegebenenfalls Fremdionen wie z.B. Alkali-Ionen enthält.

10. Solarzelle. nach Anspruch 1, **dadurch gekennzeichnet**, daß die Passivierungsschicht (5, 11, 18) Aluminiumoxid oder Aluminiumoxinitrid enthält oder daraus besteht.

11. Solarzelle nach Anspruch 1, **dadurch gekennzeichnet**, daß die Passivierungsschicht (5, 11, 18) aus aus der Gasphase abgeschiedenem Siliziumoxid ist.

12. Solarzelle nach Anspruch 1, **dadurch gekennzeichnet**, daß die Passivierungsschicht (5, 11, 18) Wasserstoff enthält.

13. Solarzelle nach Anspruch 1, **dadurch gekennzeichnet**, daß die Passivierungsschicht (5, 11, 18) eine Dicke zwischen 2 nm und 300 nm aufweist.

14. Solarzelle nach Anspruch 6, **dadurch gekennzeichnet**, daß der MIS-Kontakt (1, 2, 3) sich über die gesamte Rückseite der Solarzelle (10) erstreckt.

15. Solarzelle nach Anspruch 1, **dadurch gekennzeichnet**, daß sich die erste und/oder zweite Passivierungsschicht (2, 5, 7, 11, 17, 18) entlang der Seitenränder zwischen Vorder- und Rückseite der Solarzelle (10, 20, 30) erstreckt.

16. Solarzelle nach Anspruch 1, **dadurch gekennzeichnet**, daß die Vorder- und/oder Rückseite der Solarzelle (10, 20, 30) texturiert ist.

17. Verfahren zur Herstellung einer Solarzelle nach einem der vorhergehenden Ansprüche, **dadurch gekennzeichnet**, daß der MIS-Kontakt aus einem p-Silizium, einer natürlichen oder einer bei Temperaturen unter 800°C hergestellten Siliziumoxidschicht und Aluminium oder Magnesium aufgebaut wird.

18. Verfahren zur Herstellung einer Solarzelle nach einem der Ansprüche 1 bis 16, **dadurch gekennzeichnet**, daß die erste Passivierungsschicht im Temperaturbereich zwischen 300°C und 600°C hergestellt und/oder in diesem Temperaturintervall getempert wird.

**Claims**

1. Solar cell (10, 20, 30) made of a semiconductor material such as silicon, in whose semiconductor substrate (1, 6, 12, 13) radiation energy generates majority and minority charge carriers which are separable by means of an electric field generated at one side of the semiconductor substrate and then dischargeable, having first ohmic contact zones (4, 10, 16) which are spaced apart from and connected to one another and are disposed on one side of and directly on the semiconductor substrate and having at least one metal contact (3, 8, 14) disposed on the other side of the semiconductor substrate, the ohmic contact zones and the semiconductor substrate extending therebetween being covered by a passivation layer (5, 11, 18), **characterised in that** the spaced-apart ohmic contact zones (4, 10, 16) are disposed on the opposite side of the semiconductor substrate (1, 6, 12, 13) to the electric field and collect the majority charge carriers, and the passivation layer (5, 11, 18) is an insulating layer which reduces the recombination of the majority and minority charge carriers.

2. Solar cell according to claim 1, **characterised in that** the ohmic contact zones (4) are disposed on the front surface of the solar cell (10), the electric field may be generated at the rear surface of the solar cell (10) and the semiconductor substrate (1) has a thickness which is slightly less than or equal to the diffusion length of the minority charge carriers in the semiconductor substrate.

3. Solar cell according to claim 1, **characterised in that** the passivation layer (5, 11, 18) is made of a different material to the oxide formed from or on the semiconductor substrate (1, 6, 12, 13).

4. Solar cell according to claim 1, **characterised in that** the semiconductor material (6, 12, 13) has a thickness which is slightly less than or equal to the diffusion length of the minority charge carriers.

5. Solar cell according to claim 1, **characterised in that** the area of the ohmic contact zones (4, 10, 16) covers less than 20% of the semiconductor substrate area.

6. Solar cell according to claim 1, **characterised in that** the electric field may be generated preferably by means of a p-n junction (12, 13) or an MIS contact (1, 2, 3) or an MIS contact (6, 7, 8) in conjunction with an electrically charged insulating layer (9).

7. Solar cell according to claim 1, **characterised in that** the passivation layer is a first passivation layer (5, 11, 18), and there is disposed between the semiconductor substrate (1, 6, 12) and the first passivation layer (5, 11, 18) a second passivation layer (2, 7, 17) made of silicon oxide, which is a natural silicon oxide or a silicon oxide produced by thermal oxidation, which has a thickness less than or equal to 5 nm.

8. Solar cell according to claim 1, **characterised in that** the passivation layer is a first passivation layer (5, 11, 18), and a hydrogenous amorphous silicon layer is disposed between the semiconductor substrate (1, 6, 12) and the first passivation layer (5, 11, 18).

9. Solar cell according to claim 1, **characterised in that** the passivation layer (5, 11, 18) is made of silicon nitride or silicon oxynitride which is preferably producible through stripping from the gas phase in a reaction vessel in a glow discharge, through light exposure or through cathode sputtering and may possibly contain foreign ions such as, for example, alkali ions.

10. Solar cell according to claim 1, **characterised in that** the passivation layer (5, 11, 18) contains or is made of aluminium oxide or aluminium oxynitride.

11. Solar cell according to claim 1, **characterised in that** the passivation layer (5, 11, 18) is made of silicon oxide stripped from the gas phase.

12. Solar cell according to claim 1, **characterised in that** the passivation layer (5, 11, 18) contains hydrogen.

13. Solar cell according to claim 1, **characterised in that** the passivation layer (5, 11, 18) has a thickness between 2 nm and 300 nm.

14. Solar cell according to claim 6, **characterised in that** the MIS contact (1, 2, 3) extends over the entire rear surface of the solar cell (10).

15. Solar cell according to claim 1, **characterised in that** the first and/or second passivation layer (2, 5, 7, 11, 17, 18) extends along the side edges between the front and rear surfaces of the solar cell (10, 20, 30).

16. Solar cell according to claim 1, **characterised in that** the front and/or rear surface of the solar cell (10, 20, 30) is textured.

17. Process for manufacturing a solar cell according to at least one of the preceding claims, **characterised in that** the MIS contact is made from a p-type silicon, a natural silicon oxide layer or a silicon oxide layer produced at temperatures below 800°C, and aluminium or magnesium.

18. Process for manufacturing a solar cell according to at least one of claims 1 to 16, **characterised in that** the first passivation layer is produced in the temperature range of between 300°C and 600°C and/or is tempered in said temperature range.

## Revendications

1. Cellule solaire (10, 20, 30) en matériau semi-conducteur comme le silicium dans laquelle le substrat semi-conducteur (1, 6, 12, 13) est produit au moyen des porteurs de charge majoritaires et minoritaires de l'énergie de rayonnement, qui sont séparables et donc dérivables au moyen d'un champ électrique engendré d'un côté du substrat semi-conducteur, avec d'un côté du substrat semi-conducteur des zones de contacts ohmiques (4, 10, 16) placées d'abord avec un certain écart les unes des autres, reliées entre elles, et placées directement sur le substrat semiconducteur, et avec au moins un contact métallique (3, 8, 14) placé de l'autre côté du substrat semiconducteur, les zones des contacts ohmiques et le substrat semi-conducteur placé entre ces dernières étant recouverts d'une couche de passivation (5, 11, 18), caractérisée en ce que, les zones de contacts ohmiques sont placées avec un certain écart les unes des autres (4, 10, 16) du côté du substrat semi-conducteur (1, 6, 12, 13) opposé au champ électrique, et rassemblent les porteurs de charge majoritaires, et en ce que la couche de passivation (5, 11, 18) est constituée par une couche isolante réduisant la recombinaison des porteurs de charge majoritaires et des porteurs de charge minoritaires.

2. Cellule solaire selon la revendication 1, caractérisée en ce que les zones de contact ohmiques (4)) sont placées sur le côté avant de la cellule solaire (10), en ce qu'on engendre le champ électrique sur le côté arrière de la cellule solaire (10), et en ce que le substrat semi-conducteur présente une épaisseur qui est un peu plus petite ou la même que la longueur de diffusion du porteur de charge minoritaire dans le substrat semi-conducteur.

3. Cellule solaire selon la revendication 1, caractérisée en ce que la couche de passivation (5, 11, 18) est constituée par un autre matériau que l'oxyde qui forme, ou qui est placé à la surface du substrat semi-conducteur (1, 6, 12, 13).

4. Cellule solaire selon la revendication 1, caractérisée en ce que le matériau semi-conducteur (6, 12, 13) présente une épaisseur qui est un peu plus petite ou la même que la longueur de diffusion du porteur de charge minoritaire.

5. Cellule solaire selon la revendication 1 caractérisée en ce que la surface des contacts ohmiques (4, 10, 16) recouvre moins de 20% de la surface du substrat semi-conducteur.

6. Cellule solaire selon la revendication 1, caractérisée en ce que le champ électrique peut être engendré au moyen, de préférence, d'une jonction - pn (12, 13) ou bien d'un contact MIS (1, 2, 3), ou bien d'un contact MIS (6, 7, 8) en liaison avec une couche isolante (9) contenant des charges.

7. Cellule solaire selon la revendication 1, caractérisée en ce que la couche de passivation constitue une première couche de passivation (5, 11, 18), et en ce qu'entre le substrat semi-conducteur (1, 6, 12) et la première couche de passivation (5, 11, 18) on a placé une seconde couche de passivation, à base d'oxyde de silicium, qui est un oxyde de silicium naturel ou bien un oxyde de silicium obtenu par oxydation thermique, et qui a une épaisseur de préférence plus petite ou égale à 5 nm.

8. Cellule solaire selon la revendication 1, caractérisée en ce que la couche de passivation constitue une première couche de passivation (5, 11, 18), et en ce qu'entre le substrat semi-conducteur (1, 6, 12) et la première couche de passivation (5, 11, 18) on a placé une couche de silicium amorphe contenant de l'hydrogène.

9. Cellule solaire selon la revendication 1, caractérisée en ce que la couche de passivation (5, 11, 18), se compose de nitrure de silicium ou d'oxynitrure de silicium, qui lui-même a été obtenu de préférence par séparation de la phase gazeuse dans un réacteur en une effluve électrique, par effet de la lumière ou par pulvérisation cathodique, contient le cas échéant des ions étrangers comme par exemple des ions alcalins.

10. Cellule solaire selon la revendication 1, caractérisée en ce que la couche de passivation (5, 11, 18) contient de l'oxyde d'aluminium ou de l'oxynitrure d'aliminium ou bien est constituée totalement de ces derniers matériaux.

11. Cellule solaire selon la revendication 1, caractérisée en ce que la couche de passivation (5, 11, 18) est constituée par de l'oxyde d'aluminium séparé de la phase gazeuse.

12. Cellule solaire selon la revendication 1, caractérisée en ce que la couche de passivation (5, 11, 18) contient de l'Hydrogène.

13. Cellule solaire selon la revendication 1, caractérisée en ce la première couche de passivation (5, 11, 18) présente une épaisseur comprise entre 2 nm et 300 nm.

14. Cellule solaire selon la revendication 1, caractérisée en ce que le contact MIS (1, 2, 3) est situé sur tout le côté arrière de la cellule solaire (10).

15. Cellule solaire selon la revendication 1, caractérisée en ce que la première et/ou la seconde couche de passivation (2, 5, 7, 11, 17, 18) est située le long des bordures latérales entre le côté avant et le côté arrière de la cellule solaire (10, 20, 30).

16. Cellule solaire selon la revendication 1, caractérisée en ce que le côté avant et/ou le côté arrière de la cellule solaire (10, 20, 30) sont texturés.

17. Procédé de fabrication d'une cellule solaire selon au moins l'une des revendications précédentes, caractérisé en ce que le contact MIS est constitué par du p-silicium, une couche d'oxyde de silicium naturel, ou fabriqué à une température inférieure à 800°C et de l'aluminium ou du magnésium.

18. Procédé de fabrication d'une cellule solaire selon au moins l'une des revendications 1 à 16, caractérisé en ce que la première couche de passivation est fabriquée à une température comprise entre 300 et 600°C et/ou est étuvée dans cet intervalle de température.

Fig. 1

EP 0 219 763 B1

Fig. 2

EP 0 219 763 B1

Fig. 3

Fig. 4

30

15

14

14

16

16

$n^+$

p

13

12

17

18